# EUROPEAN PATENT APPLICATION

(11) **EP 3 570 333 A1**
(43) Date of publication of application: **20.11.2019**
(21) Application number: 17891795.1
(22) Date of filing: 12.01.2017
(51) Int. Cl.: H01L 31/18

(54) **COLOR SOLAR ENERGY MODULE AND FABRICATION METHOD THEREFOR**

(71) Applicant: Rab Global Green SDN. BHD., Negara Brunei Draussalam BF2520 (BN); Che, Huizhong, Shenzhen, Guangdong 518067 (CN)
(72) Inventor: CHE, Huizhong, Shenzhen Guangdong 518067 (CN); HSU, Chien Chih, Negara Brunei Draussalam BF2520 (BN); GUO, Dayu, Negara Brunei Draussalam BF2520 (BN)
(74) Representative: Danubia Patent & Law Office LLC
(86) International application number: PCT/CN2017/070954
(87) International publication number: WO 2018/129688

(57) **Abstract**

A color solar energy module and fabrication method therefor, the color solar energy module comprising a solar cell module (200) and a color pattern layer (100). The color pattern layer (100) comprises a white ink layer (110) and a multi-color ink layer (120). The white ink layer (110) is formed on a surface of the solar cell module (200), and the multi-color ink layer (120) is formed on a surface of the white ink layer (110). The white ink layer (110) comprises a plurality of grid-shaped patterns formed by a plurality of white ink spots (111), which are regularly arranged, and a first light transmitting gap (112) used for light penetration is formed between each white ink spot (111), wherein the width of each first light transmitting gap (112) is between 0.002 micrometers and 0.015 micrometers. The multi-color ink layer (120) comprises a plurality of grid-shaped patterns formed by a plurality of color ink spots (121), which are regularly arranged, and a second light transmitting gap (122) used for light penetration is formed between each color ink spot (121), wherein the width of each second light transmitting gap (122) is between 0.002 micrometers and 0.015 micrometers. The fabrication of the color solar energy module is simple and easy, more saturated color patterns may be presented, and the loss of luminous efficiency caused by the color patterns is small.

## Description

### BACKGROUND OF THE INVENTION

### Technical Field

The present invention relates the technology of direct conversion of light into electricity, particularly to the building integration photovoltaic technology.

### Description of Related Art

Recently, in order to meet the solar market demand, while continuously improving power conversion efficiency, the appearance of solar devices is also required to be more humanized and friendly to the environment. When more and more solar power stations being under construction, building integration photovoltaic modules (BIPV) being more popular, colourful and aesthetic solar power components become wishfully requirements. Using solar energy products as building materials or components, people want to choose their favorite colors and figures to decorate their own buildings, so as to highlight the personality of householders.

Regarding to a prior art of colourful solar power devices, China patent CN01815233.3 pertains to a solar cell unit comprising a back electrode, a photovoltaic (PV) layer, and, optionally, a front electrode, with part of the surface of the solar cell unit not generating energy, wherein at least part of the non-energy-generating part of the solar cell unit is provided with a coloring material, while at least part of the energy-generating part of the solar cell unit is free of a coloring material, the color of the coloring material being different from that of the solar cell unit. If so desired, part of the non-energy-generating part of the solar cell unit may be provided with a camouflage material. The present invention makes it possible to select the color impression of the solar cell unit and/or decorate the solar cell unit while the electrical output of the solar cell unit is not affected.

Regarding to another prior art of colourful solar power devices, China patent CN200920318921.7 discloses an integrated photovoltaic technique, in particular to a colorized solar battery assembly for a building, which is manufactured by fixing an amorphous silicon film solar cell assembly to glass or toughened glass through a colorized laminated layer. The utility model is characterized in that an integral photoelectric curtain wall assembly formed by the amorphous silicon film solar cell assembly, the colorized laminated layer and the glass or the toughened glass, wherein the amorphous silicon film solar cell assembly is fixed on the glass or the toughened glass through the colorized laminated layer; the amorphous silicon film solar cell assembly is formed by combining a plurality of amorphous silicon film solar cells and gaps are reserved; the amorphous silicon film solar cell assembly is connected with electrodes through aluminum foil; transparent materials are filled in the gaps; and the amorphous silicon film solar cell assembly is pressed between two pieces of glass or toughened glass through the colorized laminated layer and is packaged by the two pieces of glass or toughened glass. The utility model has the advantages of various colors, wide application range, low cost, convenient construction and installation, long service life and the like.

Regarding to another prior art of colourful solar power devices, China patent CN201110225590.4 discloses a method for preparing a color solar cell with a pattern. By the preparation method provided by the invention, any pattern can be manufactured on a part of the surface of the color solar cell; and the preparation method is simple and closely combined with a conventional production process to rapidly realize industrialization. The color solar cell prepared by the method can avoid electrical property loss. By the method, a required pattern can be randomly drawn on the color solar cell to satisfy different needs and expand the application fields of the color solar cell. The color solar cell, manufactured by the method, with the pattern has a simple structure, distinctive characteristics, the delicate pattern and good energy saving and environmental protection effects, is applicable as an ornament and meets different using demands.

Regarding to another prior art of colourful solar power devices, China patent CN201220432249.6 discloses a colored photovoltaic module made of colored solar cells. The colored solar cell photovoltaic module comprises toughened glass, EVA, color solar cell plates, EVA and a back plate which are sequentially arranged from top to bottom, wherein the color solar cell plates are composed of color solar cell plates in which a single plate contains more than two kinds of colors. The photovoltaic module has the advantages of simple structure and distinctive features, and can meet the requirements for colors of building and environment integration.

### SUMMARY OF THE INVENTION

The objective of the present invention is to provide a colourful solar power module, which being more easily for manufacturing. The colourful solar power module is of a coloured pattern more brilliant than any other prior arts. Therefore, the colourful solar power module proposed in the present invention is artistic with sufficient power generation efficiency to be applied for BIPV such as advertising hoards, construction materials, installation arts, etc.

The present invention provides a colourful solar power module 1, which comprising a solar battery 200 and a coloured pattern layer 100. The coloured pattern layer 100 comprises a white ink layer 110 and a multi-colour ink layer 120. The white ink layer 110 is formed on the surface of the solar battery 200. The multi-colour ink layer 120 is formed on the surface of the white ink layer 110. The white ink layer 110 comprises a white latticed pattern which consisting of a plurality of white ink dots 111. A plurality of first light through clearances 112 are formed between the white ink dots 111. Preferably, each of first light through clearances 112 has a width ranging from 0.002 mm to 0.015 mm. The multi-colour ink layer 120 comprises a coloured latticed pattern which consisting of a plurality of coloured ink dots 121. A plurality of second light through clearances 122 are formed between the coloured ink dots 121. Preferably, each of second light through clearances 122 has a width ranging from 0.002 mm to 0.015 mm.

In the meantime, the present invention provides a manufacturing method of colourful solar power module, comprising the following steps:
S610: providing a solar battery 200;
S620: providing a coloured pattern which fitting the size of the solar battery 200;
S630: inkjet printing a white ink layer 110 on the surface of the solar battery 200, the white ink layer 110 comprising a white latticed pattern which consisting of a plurality of white ink dots 111, a plurality of first light through clearances 112 being formed between the white ink dots 111; S640: UV curing the white ink layer 110;
S650: inkjet printing a multi-colour ink layer 120 on the white ink layer 110, the multi-colour ink layer 120 comprising a coloured latticed pattern which consisting of a plurality of coloured ink dots 121, a plurality of second light through clearances 122 being formed between the coloured ink dots 121; and
S660: UV curing the multi-colour ink layer 120, thereafter, a coloured pattern layer 100 being formed on the solar battery 200.

The colourful solar power module and its manufacturing method proposed in the present invention applies inkjet printing technique to form a coloured pattern layer on the surface of the solar battery. In the coloured pattern layer, the underlayment is a white ink layer which contributing the brilliance of the coloured pattern. The coloured pattern layer is characterized in its lattice configuration with a plurality of first light through clearances and second light through clearances, so as to have better light through effect and less reduction of power generation. The colourful solar power module and its manufacturing method proposed in the present invention can be easily and widely applied in various species of solar batteries, such as monocrystalline silicon, polysilicon, amorphous, dye sensitization, etc.

### BRIEF DESCRIPTION OF THE DRAWINGS AND SYMBOLS

Fig. 1 shows a first preferred embodiment of the present invention, which being a diagrammatic drawing of the colourful solar power module. Fig. 2 shows a diagrammatic drawing of the coloured ink dots and the second light through clearances in the multi-colour ink layer.
Fig. 3 shows a diagrammatic drawing of the first thickness and the second thickness in the white ink layer.
Fig. 4 shows a second preferred embodiment in the present invention which being a flow chart of the manufacturing method of the colourful solar power module.

Notations in the figures are listed below:
colourful solar power module 1
solar battery 200
roughened layer 210
coloured pattern layer 100
white ink layer 110
white ink dot 111
first light through clearance 112
titanium dioxide particle 113
multi-colour ink layer 120
coloured ink dot 121
second light through clearance 122
first thickness 115
second thickness 116
manufacturing step S610, S615, S620, S630, S640, S650, S660

### DETAILED DESCRIPTION OF THE PREFERRED EMBODIMENT

While the present invention discloses an improvement of solar module, underlayment of photovoltaic conversion effects are well known in the art and need not be discussed at length herein. In addition, the accompanying figures and dimensions disclosed herewith are only for illustrating features provided in the present invention without limiting the patent rights.

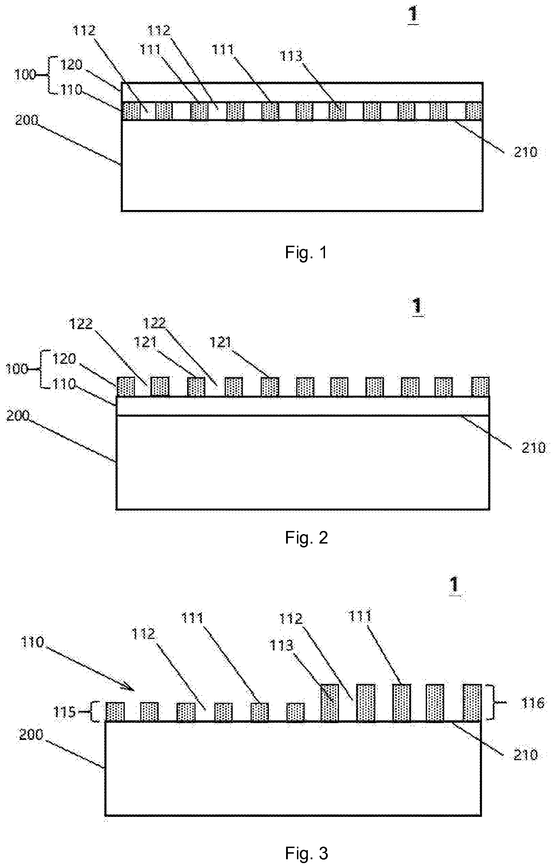

Please refer to Fig. 1, which being a first preferred embodiment proposed in the present invention, a colourful solar power module 1 is disclosed. The colourful solar power module 1 comprises a solar battery 200 and a coloured pattern layer 100.

The coloured pattern layer 100 comprises a white ink layer 110 and a multi-colour ink layer 120. The white ink layer 110 is formed on the surface of the solar battery 200. The multi-colour ink layer 120 is formed on the surface of the white ink layer 110. The solar battery 200 is preferred to be a well packaged solar battery with a surface layer such as glass, polyethylene glycol terephthalate, EPOXY, or any other light transmittable materials.

The white ink layer 110 in the present invention provides an important function as a underlayment layer of the coloured pattern. For most of well packaged solar batteries, the surface colour is black or indigo which being too dark to form brilliant coloured pattern. If there is no any appropriate underlayment layer, the direct formed coloured pattern costs a lot of ink and results in bad visual effect. The present invention uses the white ink layer 110 as a underlayment layer not only for changing the surface colour of the solar battery to make the coloured pattern more easily to be formed, but also for reflecting the sun light, hence the coloured pattern on the solar battery will be more brilliant.

One the other hand, the white ink layer 110 also shadows the sun light, therefore, the white ink layer 110 is substantially a white latticed pattern which consisting of a plurality of regularly arranged white ink dots 111. A plurality of first light through clearances 112 are formed among the white ink dots 111, as shown in Fig. 1. The sun light then passes through first light through clearances 112 into the solar battery 200 for photovoltaic conversion.

The first light through clearances 112 in the present invention play an important roll. If there is no reasonable amount of first light through clearances 112 in the white ink layer 110, light will be shadowed and is not able to go into the solar battery 200 which positioned under the white ink layer 110, the photovoltaic conversion efficiency is seriously reduced. For precisely controlling the density and the width of first light through clearances 112, the white ink layer 110 is preferably formed via the digitally controlled inkjet printer with UV curing function.

The width of the first light through clearance 112 must be appropriately configured. Considering the photovoltaic conversion in the solar battery 200 is reacted by visible light of the wavelength ranging from 380 nanometers to 760 nanometers, the width of the first light through clearance 112 must be set according to the wavelength of the visible light.

Based on numerous experiments and tests, the first light through clearance 112 is of a preferable width ranging from 0.002 mm to 0.015 mm, and more preferably ranging from 0.004 mm to 0.014 mm. For the wider first light through clearance 112, the better light through but the worse underlayment. For the narrower first light through clearance 112, the worse light through but the better underlayment.

Among first light through clearances 112, a plurality of lines consisting of white ink dots 111 are thereby formed. The width of such lines is also an important parameter. For the wider width, the better underlayment but worse light through. For the narrower width, the better light through but the worse underlayment. In the present invention, preferably, the width of lines of the white ink dots 111 is approximate to the width of the first light through clearance 112.

For precisely controlling the density and the width of first light through clearances 112 and the width of lines of white ink dots 111, the white ink layer 110 is preferably formed via the digitally controlled inkjet printer with UV curing function.

For controlling the width of lines of white ink dots 111, two parameters could be applied: the amount of the white ink, and the intensity of UV curing radiation. When the amount of the white ink controlled, the intensity of UV curing radiation increases, the sizes of the white ink dots 111 decreases. Normally, when white ink drops fall on the surface of the solar battery 200, the white ink drops splash due to counterforce. When the intensity of UV curing radiation increases, the curing effect of the white ink accelerates and advances, it results the less splash when the white ink drops fall on the surface of the solar battery 200 because the white ink drops get stiffer and more solid, the resulting white ink dots 111 are therefore smaller. Correspondingly, When the intensity of the UV curing radiation is controlled, the more amount of the white ink results in the bigger size of the white ink dots 111; the less amount of the white ink results in the smaller size of the white ink dots 111.

For the case of 720 DPI inkjet printing, there are 720*720=518,400 dots in per squared inches. The normal thickness of the white ink layer 110 is 0.01 mm, the size of each white ink dot 111 ranges from 0.005 to 0.01 squared millimeters because the ink drops splash when falling on on the surface of the solar battery 200. It results that the first light through clearance 112 has a width ranging from 0.002 mm to 0.007 mm, thereby the visible light having wavelength ranging from 380 nanometers to 760 nanometers will passes through the first light through clearance easily. When need higher photovoltaic conversion efficiency, for a specific amount of ink, the width of the first light through clearance 112 can be increased by increasing the intensity of the UV curing radiation, while the thickness of the white ink layer 110 is also increased in the mean time. For example, when the thickness of the white ink layer 110 increases from 0.01 mm to 0.015 mm, the width of the first light through clearance 112 correspondingly increases 50%, thus more visible light will pass through the first light through clearances 112 and go into the solar battery 200. In this preferred embodiment, the coloured pattern is configured by a multi-colour ink layer 120. Please refer to Fig. 2, the multi-colour ink layer 120 comprises a coloured latticed pattern which consisting of a plurality of regularly arranged coloured ink dots 121. A plurality of second light through clearances 122 are formed among the coloured ink dots 121. The second light through clearances 122 are provided for allowing light passing and going into the solar battery 200 and resulting in photovoltaic conversion. Preferably, The colourful ink used in the multi-colour ink layer 120 comprises at least four colours of ink, such as cyan ink, red ink, yellow ink, and black ink, thereby the coloured latticed pattern could be inkjet printed excellently.

The width of the second light through clearance 122 must be also appropriately configured. For wider width, the more amount of light through, but the worse coloured pattern quality. For narrower width, the better coloured pattern quality, but the less amount of light through. Based on numerous experiments and tests, the second light through clearance 122 is of a preferable width ranging from 0.002 mm to 0.015 mm, and more preferably ranging from 0.004 mm to 0.014 mm.

In the coloured pattern, a plurality of lines consisting of the regularly arranged coloured ink dots 121 are formed. The width of the lines formed by the regularly arranged coloured ink dots 121 is also an important performance parameter. For wider width of the lines, the better coloured pattern quality, but the worse photovoltaic conversion efficiency. For narrower width of the lines, the worse coloured pattern quality, but the better photovoltaic conversion efficiency. Preferably, the width of the lines formed by the regularly arranged coloured ink dots 121 is approximate to the width of the second light through clearances 122.

For precisely controlling and the width of second light through clearances 122 and the width of lines of coloured ink dots 121, the multi-colour ink layer 120 is preferably formed via the digitally controlled inkjet printer with UV curing function.

Considering both the light through and brilliance of the coloured pattern, the multi-colour ink layer 120 is of a preferred thickness ranging from 0.01 mm to 0.015 mm.

According to technical conception in the present invention, the coloured pattern layer 100 could be either planar or three dimensional. For the planar case, each of the white ink layer 110 and the multi-colour ink layer 120 is of a uniform thickness, wherein the thickness of the white ink layer 110 is approximate to the thickness of the multi-colour ink layer.

For the three dimensional case, the multi-colour ink layer 120 is of a uniform thickness, while the white ink layer 110 is of various thicknesses at various portions and/or locations.

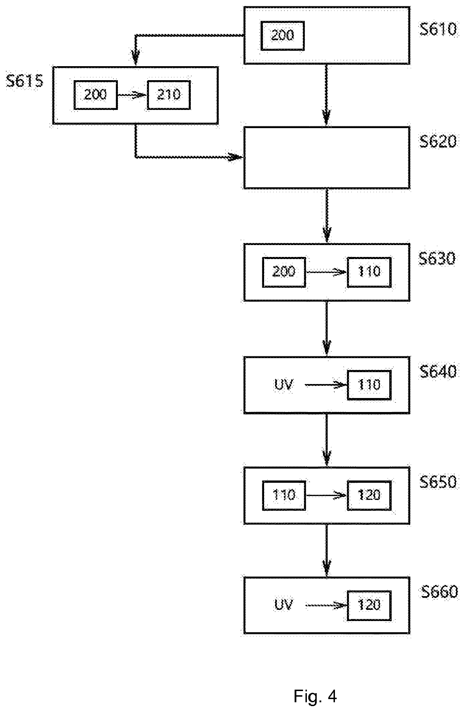

For the three dimensional case, please refer to Fig. 4, the white ink layer 110 comprises a first thickness 115 and a second thickness 116. The first thickness 115 ranges from 0.01 mm to 0.015 mm, the second thickness 116 are thicker than the first thickness 115. The locations of the second thickness are predetermined to show three dimensional effects. The thicker of the second thickness 116, the better the three dimensional effect. In the present invention, the second thickness 116 is two times the first thickness 115. In the manufacturing, the white ink layer 110 of two thicknesses is inkjet printed and UV cured on the solar battery 200, the multi-colour ink layer 120 of a uniform thickness is then inkjet printed and UV cured on the white ink layer 110, finally the three dimensional coloured pattern layer 100 is shown.

Although the three dimensional effect will also be achieved by making the multi-colour ink layer 120 to be of various thicknesses, it costs less by adjusting the thickness of the white ink layer 110. The colourful ink is usually expensive than the white ink. The way of inkjet printing a white layer is simpler than the way of inkjet printing a colourful layer. Moreover, the light shadowed by the white ink layer 110 is less than the light shadowed by the multi-colour ink layer 120. Therefore, it is preferable to show three dimensional effect by adjusting the white ink layer 110.

In the present invention, preferably, the white ink layer 110 further comprises a plurality of titanium dioxide particles 113 as shown in Fig. 1 and Fig. 3. The titanium dioxide is a good photocatalyst for photovoltaic conversion. In the meantime, the titanium dioxide particles 113 show a colour of white. When titanium dioxide particles are blended and mixed in the white ink, the inkjet printed white ink layer 110 still shows white. Meanwhile, titanium dioxide particles 113 are of particular functions for light reflecting and light scattering. The amount of light passing through the white ink layer 110 with titanium dioxide particles 113 inside is more than the amount of light passing through the white ink layer 110 without titanium dioxide particles inside.

Please refer to Fig. 1 and Fig. 3, for improving the light through effect and the bonding strength between the white ink layer 110 and the solar battery 200, a roughened layer 210 is further provided on the top of the solar battery 200. Whereby the white ink layer 110 is inkjet printed on the roughened layer 210 of the solar battery 200.

The roughened layer 210 is preferably formed on the surface substance, such as glass, EPOXY, PET, etc. of the solar battery 200. More particularly, sand paper grinding or sand blasting is preferred. The sand particle diameter of the sand paper and the sand blasting is preferred to be less than 10 mm.
Please refer to Fig. 4, the present invention further provides a second preferred embodiment, which being a manufacturing method for manufacturing a colourful solar power module disclosed in the first preferred embodiment.

The manufacturing method comprises steps S610 to S660 as the followings:
S610: To provide a solar battery 200.
S620: To provide an appropriate coloured pattern based on the surface size of the solar battery 200.
S630: To inkjet print a white ink layer 110 on the surface of the solar battery 200. The white ink layer 110 comprises a white latticed pattern which consisting of a plurality of regularly arranged white ink dots 111. A plurality of first light through clearances 112 are formed among the white ink dots 111.
S640: To UV cure the white ink layer 110.
S650: To inkjet print a multi-colour ink layer 120 on the white ink layer 110. The multi-colour ink layer 120 comprises a coloured latticed pattern which consisting of a plurality of regularly arranged coloured ink dots 121. A plurality of second light through clearances 122 are formed among the coloured ink dots 121.
S660: To UV cure the multi-colour ink layer 120. Whereby, a coloured pattern layer 100 are formed on the surface of the solar battery 200.

For taking account of the photovoltaic conversion efficiency and the brilliance of the coloured pattern, the following dimensions are suggested:
The first light through clearances 112 are of a width ranging from 0.002 mm to 0.015 mm, preferably ranging from 0.004 mm to 0.014 mm.

The lines formed by the white ink dots 111 are of the width approximate to the width of the first light through clearances 112.

The second light through clearances 122 are of a width ranging from 0.002 mm to 0.015 mm, preferably ranging from 0.004 mm to 0.014 mm.

The lines formed by the coloured ink dots 121 are of a width approximate to the width of the second light through clearances 122. In this preferred embodiment, either a planar coloured pattern layer 100 or a three dimensional coloured pattern layer 100 is achieved. For the case of planar coloured pattern layer 100, the white ink layer 110 and the multi-colour ink layer 120 are of a thickness ranging from 0.01 mm to 0.015 mm.

The coloured pattern layer 100 in the present invention could be either planar or three dimensional. When three dimensional coloured pattern layer 100 is desired, in step S630, the white ink layer 110 comprises two different thicknesses, i.e., a first thickness 115 and a second thickness 116. The first thickness 115 ranges from 0.01 mm to 0.015 mm, the second thickness 116 is at least two times of the first thickness 115. The locations of the second thickness are designed to show the three dimensional effect. Consequently, in step S650, the multi-colour ink layer 120 is inkjet printed with a uniform thickness. Via the higher second thickness 116 of the white ink layer 110, the multi-colour ink layer 120 on the locations of the second thickness 116 will be higher, so the three dimensional effect is shown.

In step 630, the white ink layer 110 further comprises a plurality of titanium dioxide particles 113. The titanium dioxide is a good photocatalyst for photovoltaic conversion. In the meantime, the titanium dioxide particles 113 also show a colour of white. When titanium dioxide particles are blended in the white ink, the inkjet printed white ink layer 110 still shows white.

Meanwhile, titanium dioxide particles 113 are of particular functions for light reflecting and light scattering. The amount of light passing through the white ink layer 110 blended with titanium dioxide particles 113 is more than the amount of light passing through the white ink layer 110 without titanium dioxide particles.

In step S650, preferably, the colourful ink used in the multi-colour ink layer 120 comprises cyan ink, red ink, yellow ink, and black ink, thereby the coloured latticed pattern could be inkjet printed excellently.

For improving the bonding strength between the white ink layer 110 and the solar battery 200, step S615 is further provided in this preferred embodiment, please refer to Fig. 4.

S615: To form a roughened layer 210 on the solar battery 200.

Whereby in the following step S630, the white ink layer 110 is inkjet printed on the roughened layer 210 of the solar battery 200.

In step S615, the roughened layer 210 is preferably formed on the surface substance, such as glass, EPOXY, PET, etc. of the solar battery 200. More particularly, sand paper grinding or sand blasting is preferred. The sand particle diameter of the sand paper and the sand blasting is preferred to be less than 10 mm.

The advantages provided by the preferred embodiments in the present invention are as the followings:
1. The coloured pattern layer 100 is formed directly on the surface of the solar battery 200. The manufacturing is easier for mass production than any of the prior arts.
2. The coloured pattern layer 100 is configured by a multi-colour ink layer 120 and a white ink layer 110 which formed under the multi-colour ink layer 120. Due to the white ink layer 110 as a perfect underlayment, the bad effect of black or indigo surface colour of the solar battery 200 is lessened. Therefore, the coloured pattern layer 100 is of better brilliance.
3. Though the coloured pattern layer would shadow the light, but he second light through clearances 122 in the multi-colour ink layer 120 and the first light through clearances 112 in the white ink layer 110 still provide sufficient light through amount. The power diminution of the solar battery 200 is lowered.
4. The colourful solar power module is of brilliant coloured pattern and sufficient power generation efficiency. It can be easily and practically applied.
   The abovementioned particular embodiments of the invention have been described in detail for purposes of illustration, it will be understood and practiced by one of ordinary skill in the art. There are numerous variations being possible to the disclosed embodiments without going outside the scope of the invention as disclosed in the claims and the equivalents.

## Claims

1. A colourful solar power module (1) comprising a solar battery (200) and
a coloured pattern layer (100), **characterized in that**:
said coloured pattern layer (100) comprising a white ink layer (110) and a multi-colour ink layer (120) ;
said white ink layer (110) being formed on the surface of said solar battery (200), said multi-colour ink layer (120) being formed on the surface of said white ink layer (110), said white ink layer (110) comprising a white latticed pattern which consisting of a plurality of white ink dots (111), a plurality of first light through clearances (112) being formed between said white ink dots (111), said first light through clearance (112) having a width ranging from 0.002 mm to 0.015 mm; said multi-colour ink layer (120) comprising a coloured latticed pattern which consisting of a plurality of coloured ink dots (121), a plurality of second light through clearances (122) being formed between said coloured ink dots (121), said second light through clearance (122) having a width ranging from 0.002 mm to 0.015 mm.

2. The colourful solar power module (1) according to claim 1, wherein, said white ink layer (110) having a thickness of 0.01 mm to 0.015 mm.

3. The colourful solar power module (1) according to claim 1, wherein, said white ink layer (110) comprising a first thickness (115) and a second thickness (116), said first thickness (115) being 0.01 mm to 0.015 mm, said second thickness (116) being at least two times said first thickness (115).

4. The colourful solar power module (1) according to claim 1, wherein, said white ink layer (110) comprising a plurality of titanium dioxide particles (113) therein, said first light through clearance (112) having a width of 0.004 mm to 0.014 mm, said second light through clearance (122) having a width of 0.004 mm to 0.014 mm.

5. The colourful solar power module (1) according to any one of claims 1 to 4, wherein, said solar battery (200) a roughened layer (210) on its surface, said white ink layer (110) is formed on said roughened layer (210).

6. A manufacturing method of colourful solar power module, comprising the following steps:
S610: providing a solar battery (200);
S620: providing a coloured pattern which fitting the size of said solar battery (200);
S630: inkjet printing a white ink layer (110) on the surface of said solar battery (200), said white ink layer (110) comprising a white latticed pattern which consisting of a plurality of white ink dots (111), a plurality of first light through clearances (112) being formed between said white ink dots (111);
S640: UV curing said white ink layer (110);
S650: inkjet printing a multi-colour ink layer (120) on said white ink layer (110), said multi-colour ink layer (120) comprising a coloured latticed pattern which consisting of a plurality of coloured ink dots (121), a plurality of second light through clearances (122) being formed between said coloured ink dots (121); and
S660: UV curing said multi-colour ink layer (120), thereafter, a coloured pattern layer (100) being formed on said solar battery (200).

7. The manufacturing method of colourful solar power module according to claim 6, further comprising:
S615: forming a roughened layer (210) on the surface of said solar battery (200); and
S630: inkjet printing said white ink layer (110) on said roughened layer (210).

8. The manufacturing method of colourful solar power module according to claim 6 or 7, wherein, said first light through clearance (112) having a width ranging from 0.002 mm to 0.015 mm, said second light through clearance (122) having a width ranging from 0.002 mm to 0.015 mm, said multi-colour ink layer (120) having a thickness of 0.01 mm to 0.015 mm.

9. The manufacturing method of colourful solar power module according to claim 8, wherein, said white ink layer (110) comprising a first thickness (115) and a second thickness (116), said first thickness (115) ranging from 0.01 mm to 0.015 mm, said second thickness (116) being at least two times said first thickness (115).

10. The manufacturing method of colourful solar power module according to claim 8, wherein, said white ink layer (110) comprising a plurality of titanium dioxide particles (113) therein.
